## Europäisches Patentamt

## European Patent Office

## Office européen des brevets

(11) Veröffentlichungsnummer: **0 073 293**
**A2**

(12) # EUROPÄISCHE PATENTANMELDUNG

(21) Anmeldenummer: **82103624.1**

(22) Anmeldetag: **28.04.82**

(51) Int. Cl.³: **H 03 H 7/09**

(30) Priorität: **01.09.81 HU 251781**

(43) Veröffentlichungstag der Anmeldung: **09.03.83**
**Patentblatt 83/10**

(84) Benannte Vertragsstaaten: **AT BE CH DE FR GB IT LI LU NL SE**

(71) Anmelder: **Veisz, György, Ráday u. 34, Budapest IX (HU)**
Anmelder: **Köszeghy, Péter, Damjanich u. 26/a, Budapest VII (HU)**
Anmelder: **Gábor, Dávid, Holdvilág u. 1, Budapest XI (HU)**
Anmelder: **Székely, Lajos, Bajcsy-Zsilinszky ut 21, Budapest VI (HU)**

(72) Erfinder: **Veisz, György, Ráday u. 34, Budapest IX (HU)**
Erfinder: **Köszeghy, Péter, Damjanich u. 26/a, Budapest VII (HU)**
Erfinder: **Gábor, Dávid, Holdvilág u. 1, Budapest XI (HU)**
Erfinder: **Székely, Lajos, Bajcsy-Zsilinszky ut 21, Budapest VI (HU)**

(74) Vertreter: **Lehn, Werner, Dipl.-Ing. et al, Hoffmann, Eitle & Partner Patentanwälte Arabellastrasse 4 (Sternhaus), D-8000 München 81 (DE)**

(54) **Vierpol.**

(57) Die Erfindung betrifft einen Vierpol, der eine Kapazität und ein mit einem induktiven Reihenglied versehenes Filterglied (20) aufweist. Das Wesen des Vierpols besteht darin, daß das induktive Reihenglied aus zueinander zugepaßten und in Reihe geschalteten, mit gegenseitigen Stromflußrichtungen charakterisierten Stromführungen (6, 7) ausgebildet ist, und im Filterglied (20) die Stromführungen an der Kapazität (8, 9, 10) angeschlossen sind. Der vorgeschlagene Vierpol verhält sich als ideale Wicklung, und bei der Resonanzfrequenz ist er praktisch völlig verlustfrei. Der Vierpol gewährleistet die Siebung und Anzeige von bestimmten Frequenzbereichen, Bändern und Werten mit hoher Genauigkeit, mit hoher Steilheit des Übergangs, er zeigt hohe Selektivität.

- 1 -

## VIERPOL

Die Erfindung betrifft einen Vierpol, der eine Kapazität sowie ein Filterglied enthält, wobei das Filterglied mit einem zwischen einem ersten Eingangspunkt und einem ersten Ausgangspunkt angeschlossenen induktiven Reihenglied versehen und zwischen einen zweiten Eingangspunkt und einen zweiten Ausgangspunkt zugeführt ist. Der erfindungsgemäße Vierpol ist derart ausgebildet, daß sein induktives Reihenglied als ideale Wicklung wirkt. Der vorgeschlagene Vierpol kann besonders vorteilig in den Schaltungsanordnungen angewendet werden, bei den ein als Schwingungskreis wirkendes Schaltelement notwendig ist.

In der theoretischen und praktischen Elektronik sind die Vierpole gut bekannt ( siehe z. B. das Buch von Hanero, J. L. und Willoner, G.: Synthesis of filters, ausgegeben von Prentice Hall im J. 1966), die als Schaltkreiseinheiten mit ihren Ausgangspunkten an eine Belastung angeschlossen sind, und zwischen diesen Punkten ein mit bestimmter Impedanz gekennzeichnetes Element enthält. Die Vierpole dienen allgemein als Filter in den teletechnischen Systemen, in der Telekommunikation, in den Meßgeräten und in den Regulatoren. Ein von ihren Varianten ist der sog. T-Filter, bei dem ein der den Eingang des Filters bestehenden Eingangspunkten und der entsprechende Ausgangspunkt durch zwei in Reihe geschaltete, und mit gleicher Stromflußrichtung gekennzeichnete Wicklungen verbunden sind, wobei die Wicklungen auch einen Transformator bilden dürfen. Die zwei Wicklungen weisen einen gemeinsamen Punkt auf, der einem Belag eines Kondensators zugeführt ist. Der andere Belag des Kondensators ist zwischen den anderen Eingangspunkt und den anderen Ausgangspunkt eingeschlossen.

Der T-Filter ist zur Auswahl bestimmter Frequenzbereiche vorgesehen. In den bestimmten Bereichen zeigt er eine relativ kleine Dampfung und an den Grenzen des Bereiches macht die Steilheit der Dampfung für jede Impedanz nur 5 bis 6 dB/Dekade aus. Dieser Wert ist ungünstig, weil in diesem Falle ein breites Übergangsband zu dem ausgewählten Frequenzbereich gehört, und darum wird die Auswahl nicht immer so verwirklicht, wie es erforderlich wäre. Die Steilheit kann verbessert werden, wenn die T-Filter in Reihe geschaltet werden, doch hat diese Lösung die bedeutende Vergrößerung der Dampfung und darum die starke Verminderung der in dem bestimmten Bereich durchgelassenen Leistung Verminderung zur Folge. Das heißt, der als Filter angewendete Vierpol leitet nicht nur

- 3 -

den ausgewählten Frequenzbereich, sondern auch einen relativ breiten Übergangsbereich weiter. Der Wert der Selektivität verbleibt auch an einem niedrigen Pegel und die Charakteristik des Filters ist von der Belastung abhängig. Falls die Beseitigung der Abhängigkeit von der Belastung notwendig ist, soll die Schaltungsanordnung des T-Filters von der Belastung abhängig bestimmt werden und kann sie ganz kompliziert sein.

Zur Beseitigung der Nachteile der einen Typ der Vierpole bildenden T-Filter wurden die Kristallfilter bearbeitet, deren Anwendung - wegen ihren relativ komplizierten Aufbau und die auch durch diese Tatsache verursachte höhere Kosten, nur dann begründet ist, wenn hohe Forderungen gegen die Steilheit des Durchgangs und gegen die Selektivität zu erfüllen sind. Im Aufbau der Kristallfilter erzeugt das größte Problem die Temperaturabhängigkeit der Parameter des Quarzkristalls und der anderen Schaltungselemente, die lediglich mit noch mehr kompliziertem Aufbau oder durch Anwendung eines Termostats beseitigt werden kann.

Die Aufgabe vorliegender Erfindung besteht in der Beseitigung der erwähnten Nachteile und in der Schaffung eines einfach und mit niedrigen Kosten herstellbaren Schaltungselementes, das sich als Schwingungskreis hoher Selektivität verhält.

Der Erfindung liegt die Erkenntnis zugrunde, daß die in den T-Filtern angewendeten Wicklungen nicht immer aus gleicher Stromflußrichtung gekennzeichneten Teilen zusammenzustellen sind, sondern, wie mit Überraschung beobachtet wurde, ist es viel zweckmäßiger, die Wicklung von Stromfüh-

- 4 -

rungen aufzubauen, worin die Stromflußrichtungen in den benachbarten Stromführungen gegenseitig sind. In diesem Falle kann das erwünschte Ergebnis auch durch Anwendung zweier geraden oder gekrümmten Leitungen erreicht werden, wenn sie nebeneinander laufen und darin die Richtungen des Stromflusses gegenseitig sind.

Es wurde die obenbeschriebene Erkenntnis an zahlreichen Modellen durchgeprüft, die entsprechende Übertragungsfunktion bestimmt und der Vierpol auch mittels einer Rechenmaschine modelliert. Aufgrund der obigen Erkenntnis wurde ein Vierpol bearbeitet, der eine Kapazität sowie ein Filterglied enthält, wobei das Filterglied mit einem zwischen einem ersten Eingangspunkt und einem ersten Ausgangspunkt angeschlossenen induktiven Reihenglied versehen und zu einem zwischen einem zweiten Eingangspunkt und einem zweiten Ausgangspunkt eingeschalteten Zwischenpunkt zugeführt ist, und erfindungsgemäß das induktive Reihenglied aus zueinander zugepaßten und in Reihe geschalteten, mit gegenseitigen Stromflußrichtungen gekennzeichneten Stromführungen ausgebildet ist, und im Filterglied die Stromführungen an der Kapazität angeschlossen sind.

Das induktive Reihenglied kann zweckmäßig als eine auf einem gemeinsamen Körper ausgebildete bifilare Wicklung aufgebaut werden. Es ist auch zweckmäßig, das induktive Reihenglied aus Leitungen herzustellen, die nötigenfalls auch gerade Strecken enthalten.

Die Kapazität des erfindungsgemäßen Vierpols kann zweckmäßig auf der Analogie der bekannten Lösung der T-Filter aus-

- 5 -

gebildet werden, wenn die Kapazität aus einem Kondensator besteht, der zwischen dem gemeinsamen Punkt der in Reihe geschalteten Elemente des induktiven Reihenglieds und dem Zwischenpunkt vorhanden ist. Es ist auch zweckmäßig, die Kapazität aus zweien Kondensatoren auszubilden, die im Filterglied vor dem Eingang und nach dem Ausgang des induktiven Reihenglieds angeordnet sind. Ihre Kapazitanz ist zweckmäßig gleich. Von der Absicht mehrerer Anwendungsmöglichkeiten kann es auch vorteilhaft sein, wenn die Kapazität drei Kondensatoren enthält, d. h. die obenbeschriebenen Anordnungen gleichzeitig in einer Schaltung verwirklicht werden.

Im erfindungsgemäßen Vierpol ist weiters auch vorteilhaft, wenn zwischen dem Filterglied und einerseits dem ersten Eingangspunkt sowie dem ersten Ausgangspunkt, andererseits je eine Wicklung angeordnet ist, mit denen in Reihe oder parallel je ein Kondensator auch eingeschaltet werden kann. Die Induktivitäten der Wicklungen sowie die Kapazitanzen der Kondensatoren sind vorteilhaft gleich.

Die Wicklungen können zweckmäßig auch auf Eisenkernen hergestellt werden.

Der erfindungsgemäße Vierpol sichert bei der Frequenz der Resonanz, nach den Berechnungen und Bemessungen, eine sehr steile Charakteristik mit dem Wert von 200 ... 220 dB/Oktave, der mit Größenordnungen höher ist, als der ähnliche Wert der traditionellen T-Filter. Der erfindungsgemäße Vierpol ist mit minimalen Kosten leicht herzustellen, und hat eine von der Belastung unabhängige Charakteristik.

Die theoretische Prüfung der erfindungsgemäßen Lösung

- 6 -

zeigt, daß auf vorgeschlagene Weise ein Schaltungselement entsteht, das sich als ideale Wicklung behaltet und bei dem Resonanzpunkt praktisch völlig verlustfrei ist. Die Verluste des erfindungsgemäßen Vierpols als Schaltungselements werden nur von dem                        Kondensators verursacht.

Der Gegenstand der Erfindung wird nachstehend an beispielsweise angeführten konkreten Vierpolen, aufgrund einiger zur Zeit realisierten Abarten mit Hinweis auf die beigefügte Zeichnung eingehend erläutert. In der Zeichnung zeigt

Fig. 1 die Schaltungsanordnung einer mit sehr engem Dämpfungsbereich gekennzeichneten Ausführung des erfindungsgemäßen Vierpols (des sog. "Lochsperrefilters"),

Fig. 2 die Verstärkung-Frequenz-Charakteristik des Vierpols nach Fig. 1,

Fig. 3 die Schaltungsanordnung einer als Hochpaß anwendbaren Ausführung des erfindungsgemäßen Vierpols,

Fig. 4 die Verstärkung--Frequenz-Charakteristik des Vierpols nach Fig. 3,

Fig. 5 die Schaltungsanordnung einer als Tiefpaß anwendbaren Ausführung des erfindungsgemäßen Vierpols,

Fig. 6 die Schaltungsanordnung einer als Tiefpaß anwendbaren anderen Ausführung des erfindungsgemäßen Vierpols,

Fig. 7 die Verstärkung--Frequenz-Charakteristik einer durch parallele Schaltung der Vierpole nach Fig. 5 und Fig. 6 erhaltenen Anordnung (des sog. "Kreuzfilters"),

Fig. 8 die Schaltungsanordnung einer als Bandsperre anwendbaren Ausführung des erfindungsgemäßen Vierpols,

0073293

Fig. 9 die Verstärkung--Frequenz-Charakteristik des Vierpols nach Fig. 8,

Fig. 10 die Schaltungsanordnung einer als Tiefpaß anwendbaren Ausführung des erfindungsgemäßen Vierpols,

Fig. 11 die Verstärkung--Frequenz-Charakteristik des Vierpols nach Fig. 10,

Fig. 12 die Schaltungsanordnung einer als Bandpaß anwendbaren Ausführung des erfindungsgemäßen Vierpols,

Fig. 13 die Verstärkung--Frequenz-Charakteristik des Vierpols nach Fig. 12,

Fig. 14 die Schaltungsanordnung einer als zur Auswahl eines
engen Frequenzbandes vorgesehenen Ausführung des erfindungsgemäßen Vierpols (des sog. "Lochauswahlfilters"),

Fig. 15 die Verstärkung--Frequenz-Charakteristik des Vierpols nach Fig. 14, und

Fig. 16 die Schaltungsanordnung einer die vielseitige Regelung ermöglichenden Ausführung des erfindungsgemäßen
Vierpols.

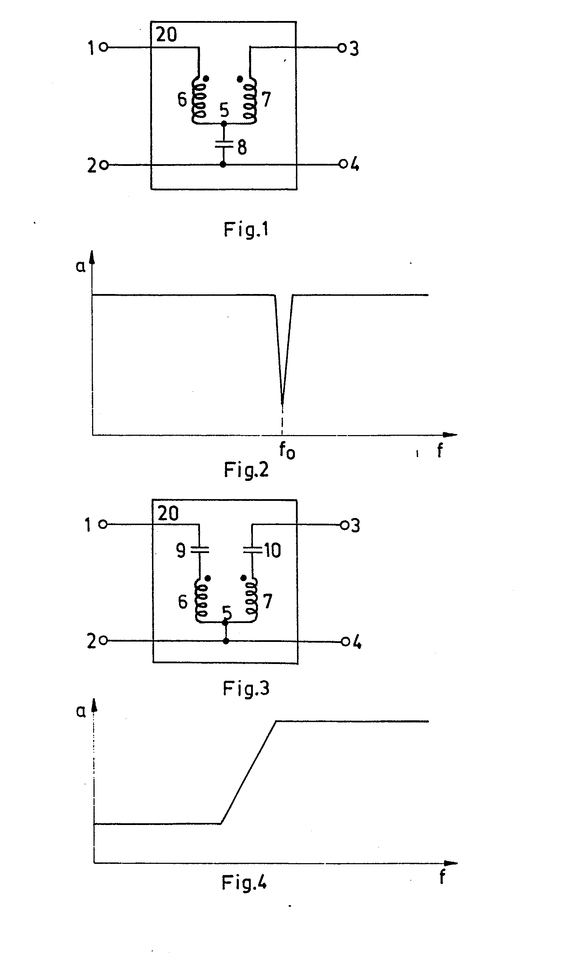

Der erfindungsgemäße Vierpol (Fig. 1) enthält ein Filterglied 20, das zwischen einem ersten Eingangspunkt 1 und einem
zweiten Eingangspunkt 2 einerseits und einem ersten Ausgangspunkt 3 und einem zweiten Ausgangspunkt 4 andererseits angeordnet ist. Im Filterglied 20 ist ein induktives Reihenglied
vorhanden, das aus Stromführungen 6, 7 besteht. Der Eingang
des Reihenglieds ist an dem ersten Eingangspunkt 1, sein Ausgang an dem ersten Ausgangspunkt 3 angeschlossen. Das induktive Reihenglied enthält einen gemeinsamen Punkt 5 der Strom-

0073293

führungen 6, 7, der zu einem zwischen dem zweiten Eingangspunkt 2 und dem zweiten Ausgangspunkt 4 bestimmten Zwischenpunkt zugeführt ist. Das induktive Reihenglied wird erfindungsgemäß derart ausgebildet, daß seine resultierende Impedanz so genau wie möglich den Nullwert aufnimmt. Das wird so erreicht, daß eine gerade Anzahl von Stromführungen 6 und 7 angewendet wird, wobei in den Stromführungen 6, 7 jedes Paares der Wert der Stromstärke gleich, doch die Stromflußrichtungen gegenseitig sind. Die Stromführungen 6, 7 sind so stark wie möglich zueinander zugepaßt, und darum ist die Anwendung der bifilaren Wicklung vorgeschlagen. In verschiedenen Anwendungsgebieten kann genügend und zweckmäßig sein, wenn die Stromführungen 6 und 7 als nebeneinander geführten, aus geraden und nötigenfalls gekrümmten Strecken bestehende Leitungen ausgebildet sind.

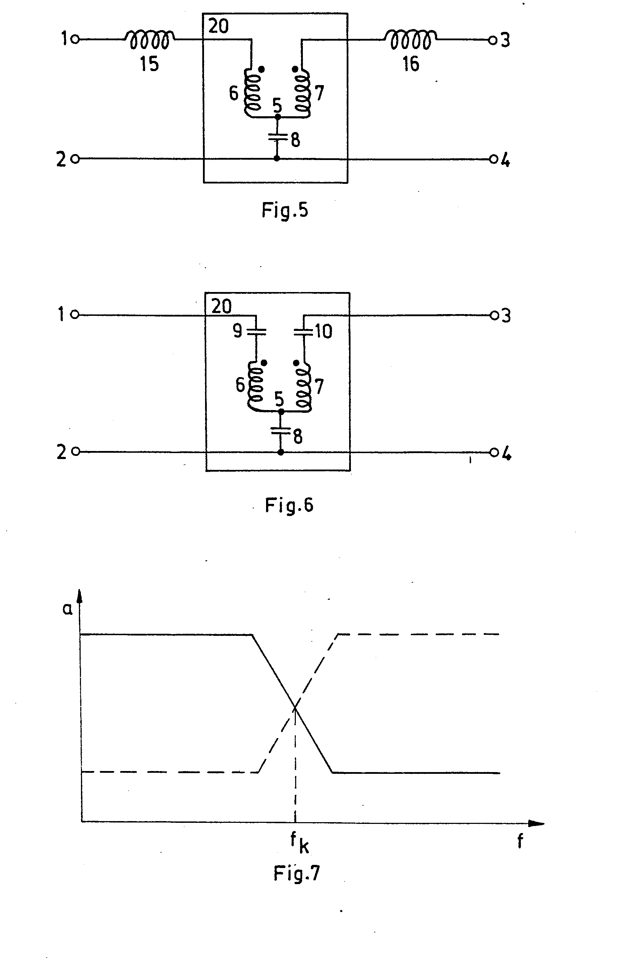

Im Filterglied 20 ist eine Kapazität entsprechend den Siebungsaufgaben zu sichern. Die Kapazität kann erfindungsgemäß aus einem Kondensator 8 (Fig. 1), aus zweien Kondensatoren 9 und 10 (Fig. 3) und aus dreien Kondensatoren 8, 9 und 10 (Fig. 6) ausgebildet werden. Der Kondensator 8 ist mit einem seinen Belag dem gemeinsamen Punkt 5 zugeführt. Der Kondensator 9 ist vor dem Eingang des induktiven Reihenglieds zwischen ihm und dem ersten Eingangspunkt 1, der Kondensator 10 zwischen dem Ausgang des induktiven Reihenglieds und dem ersten Ausgangspunkt 3 vorgesehen.

Falls die Kapazität aus einem Kondensator 8 besteht, benimmt sich der erfindungsgemäße Vierpol als Lochsperrefilter (d. h. Bandsperre mit verengertem Sperrbereich), der in der Funktion der Frequenz des durch den ersten Eingangspunkt 1 und den zweiten Eingangspunkt 2 eingeleiteten Stroms die Verstärkung a gemäß Fig. 2 sichert. Die Charakteristik beweist, daß der Vierpol praktisch in vollem Veränderungsbereich der Frequenz eine identisch gleiche Verstärkung a gewährleistet, er vernaltet sich als ein rein ohmischer Widerstand, doch in enger Umgebung einer bestimmten Resonanzfrequenz $f_0$ vermindert sich die Verstärkung beinahe sofort zum praktisch nullen Wert. Die Verminderung läuft sehr schnell ab, die Steilheit beträgt 200 bis 220 dB/Oktave, d. h. ist sie sehr hoch. Dementsprechend kann der gemäß Fig. 1 ausgebildete Vierpol z. B. zur Signalisierung der Erreichung eines charakteristischen Wertes angewendet werden. Die schnelle Abänderung der Verstärkungsverhältnisse gewährleistet die zuverlässige Anzeige. Der Wert des Kondensators 8 ist zweckmäßig in den Bereichen zwischen den Pikofaraden und den Mikrofaraden zu wählen: die kleineren Werte verursachen die Verminderung der Tiefe und die Vergrößerung der Steilheit der Frequenzbeschneidung, und die größeren Werte führen, umgekehrt, zur Vergrößerung der Tiefe und Verminderung der Steilheit der Frequenzbeschneidung. Wenn das induktive Reihenglied als Wicklung ausgebildet wird, die Wicklungszahl beeinflußt die Wicklungszahl die obigen Zusammenhänge.

Falls die Kapazität aus zweien Kondensatoren 9 und 10 besteht (Fig. 3), kann ein Hochpaß mit einer Charakteristik nach Fig. 4 hergestellt werden, der die interessante Eigenschaft aufweist, daß er eine ideale Sinuswelle erzeugt, wenn durch die ersten und zweiten Eingangspunkten 1 und 2 ein dem Diracschen Delta ähnliches Signal eingeleitet wird. Diese Anordnung als Filter läßt, wie in Fig. 4 sichtbar ist, die höheren Frequenzen mit höherer Verstärkung durch. Die Tiefe der Frequenzbeschneidung kann sehr leicht reguliert werden, wenn die Kapazitanzen der Kondensatoren 9 und 10 verschieden sind. Mit dem Unterschied der Kapazitanzwerte wird die Tiefe der Frequenzbeschneidung größer.

Bei der Anwendung dreier Kondensatoren zur Ausbildung der Kapazität (Fig. 6) vermindert sich die Steilheit der Frequenzbeschneidung.

Der erfindungsgemäße Vierpol wird weiters an Ausführungsbeispielen näher erläutert.

BEISPIEL 1

Ein von uns als Kreuzfilter genannter Filter wird derart ausgebildet, daß der erfindungsgemäße Vierpol mit dreien Kondensatoren versehen und mit einem derartig ausgeführten erfindungsgemäßen Vierpol parallel geschaltet wird, dessen Filterglied einen Kondensator enthält (Fig. 5 und 6). In dem zweiten Vierpol ist eine Wicklung 15 in Reihe zwischen dem ersten Eingangspunkt 1 und dem Filterglied 20 sowie eine Wicklung 16 zwischen dem Filterglied 20 und dem ersten Ausgangspunkt 3 geschaltet. Durch die parallele Schaltung der beschriebenen Vierpole entsteht ein Filter mit der in Fig. 7 sichtbaren Charakteristik, wobei der Vierpol gemäß Fig. 5 die kontinuierliche und der gemäß Fig. 6 die unterbrochene Linie sichert. Die Frequenzbeschneidung folgt mit einer Kreuzfrequenz $f_k$.

## BEISPIEL 2

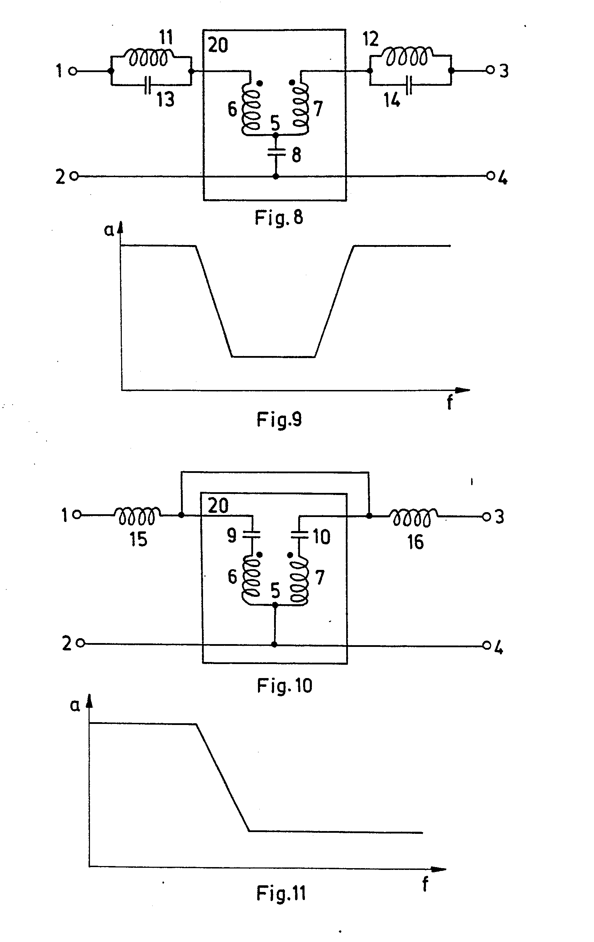

Der erfindungsgemäße Vierpol wird mit einem Filterglied 20 versehen, das mit zweien parallelen Gliedern verbunden ist. Jedes parallele Glied enthält eine Wicklung 11, bzw. 12 und einen mit der Wicklung parallel geschalteten Kondensator 13, bzw. 14 und es ist dem ersten Eingangspunkt 1 bzw. dem ersten Ausgangspunkt 3 zugeführt (Fig. 8). Die Impedanz der Wicklungen 11 und 12, sowie die Kapazitanz der Kondensatoren 13 und 14 sind vorteilig gleich, weil in diesem Falle die symmetrische Filtercharakteristik nach Fig. 9 erreicht wird.

## BEISPIEL 3

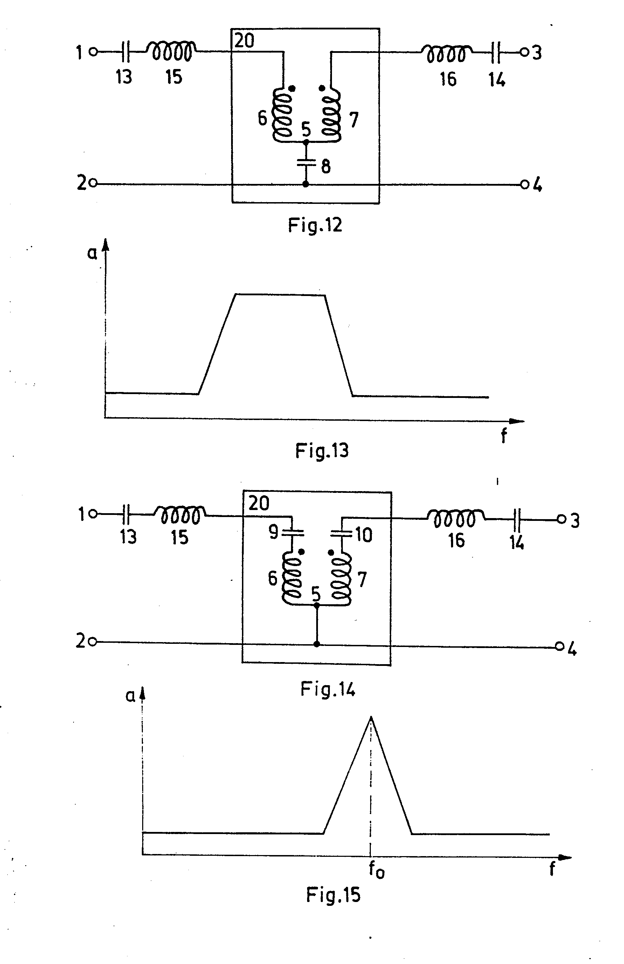

Falls der erfindungsgemäße Vierpol mit einem zwei Kondensatoren enthaltenden Filterglied 20 versehen wird, und zwischen dem Filterglied 20 und dem ersten Eingangspunkt 1 sowie dem dem ersten Ausgangspunkt 3 je Wicklung 15, 16 in Reihe eingeschaltet wird, und die näher zu dem Filterglied 20 liegenden Endpunkte der Wicklungen 15, 16 miteinander verbunden werden (Fig. 10), wird ein Tiefpaß zusammengestellt, dessen Charakteristik in der Fig. 11 sichtbar ist. Die Tiefe und die Steilheit dieses die höheren Frequenzen nicht durchlassenden Filters kann einerseits durch das Verhältnis der Impedanzen der Wicklungen 15, 16 andererseits mit entsprechender Auswahl der absoluten Größe dieser Impedanzen geregelt werden. In dem beispielsweise dargestellten Vierpol bewies es vorteilig, den Kondensatoren 9 und 10 gleiche Kapazitanz und den Wicklungen 15 und 16 gleiche Impedanz zu wählen.

## BEISPIEL 4

Das Filterglied 20 wurde mit einem Kondensator ausgebildet. Zwischen ihm und dem ersten Eingangspunkt 1 einerseits, sowie dem ersten Ausgangspunkt 3 andererseits können die Wicklung 15 und der Kondensator 13 einerseits, sowie die Wicklung 16 und der Kondensator 14 andererseits in Reihe eingeschaltet werden (Fig. 12). In dieser Anordnung sollen die Wicklungen 15, 16 mit dem Filterglied 20 gebunden werden. Derart entsteht ein Bandpaß, dessen Charakteristik in Fig. 13 sichtbar ist. Die Breite des durchgelassenen Bandes, die Tiefe der Frequenzbeschneidung sowie die Steilheit des Übergangs können durch entsprechende Auswahl der Werte der angewendeten Elemente verändert werden.

BEISPIEL 5

Das Filterglied 20 wird mit zwei Kondensatoren ausgebildet. Die Kondensatoren 13, 14 sowie die Wicklungen 15, 16 sind dem Beispiel 4 gemäß einzuschalten (Fig. 14). Derart entsteht ein Filter, wobei das durchgelassene Band bis zu einem Punkt verengt werden kann. Die Charakteristik dieses "Lochauswahlfilters" ist in Fig. 15 sichtbar, und enthält einen charakteristischen Punkt mit der Resonanzfrequenz $f_0$.

BEISPIEL 6

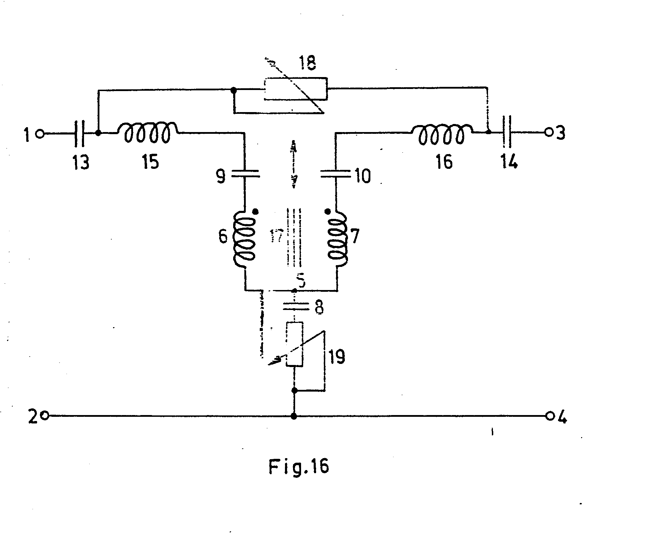

Die Regelungsmöglichkeiten des erfindungsgemäßen Vierpols folgen aus der Anwendung von in verschiedenen Stellen eingebauten Regelungselementen und Verbindungen (Fig. 16). Z. B. durch Anwendung eines regelbaren Widerstands 18, der die gemeinsamen Punkte der Wicklung 15 und des Kondensators 13 sowie der Wicklung 16 und des Kondensators 14 (wobei diese Elemente gemäß Beispiel 4 oder 5 eingeschaltet sind) kann die Tiefe der Frequenzbeschneidung leicht verändert werden. Die Reihenfolge der Elemente bei der Reihenschaltung bestimmt, ob der Filter die höheren, oder die niedrigeren Frequenzen durchläßt. Zwischen dem Kondensator 8 und den Ausgängen des Filterglieds 20 kann auch ein regelbarer Widerstand 19 eingeschaltet werden, der zur Regulierung der Tiefe der Frequenzbeschneidung geeignet ist.

In mehreren Anwendungen ist es zweckmäßig, die Stromleitungen 6, 7 des induktiven Reihenglieds sowie die Paare der Wicklungen 11, 12, 15, 16 auf entsprechenden Eisenkernen auszubilden. In diesem Falle vermindert sich die Steilheit der Charakteristik, wird jedoch der Vierpol zur Aufnahme höherer Leistungen fähig. Eine interessante Möglichkeit besteht darin, daß in den mit einer Resonanzfrequenz charakterisierten Anordnungen (z.B. Fig. 1 und 14) auf den Eisenkern so starke Kräfte bewirken, die seine Bewegung hervorrufen können bei der Erreichung der Resonanzfrequenz. Derart wird der erfindungsgemäße Vierpol selbst zur Betätigung eines Schalters, zu wirksamer Anzeige eines Grenzwertes, zur Durchführung bestimmter Meßaufgaben geeignet sein.

Der erfindungsgemäße Vierpol gewährleistet die Siebung und Anzeige von bestimmten Frequenzbereichen, Bändern und Werten. Er zeigt hohe Selektivität und ist mit einem Eisenkern versehen zur Durchführung von Schaltoperationen fähig.

PATENTANSPRÜCHE:

1. Vierpol, der eine Kapazität sowie ein Filterglied enthält, wobei das Filterglied mit einem zwischen einem ersten Eingangspunkt und einem Ausgangspunkt angeschlossenen induktiven Reihenglied versehen und zu einem zwischen einem zweiten Eingangspunkt und einem zweiten Ausgangspunkt eingeschalteten Zwischenpunkt zugeführt ist, dadurch gekennzeichnet, daß das induktive Reihenglied aus zueinander zugepaßten und in Reihe geschalteten, mit gegenseitigen Stromflußrichtungen charakterisierten Stromführungen (6, 7) ausgebildet ist, und im Filterglied (20) die Stromführungen (6, 7) an der Kapazität angeschlossen sind.

2. Vierpol nach Anspruch 1, dadurch gekennzeichnet, daß die Stromführungen (6, 7) eine bifilare Wicklung bilden.

3. Vierpol nach Anspruch 1, dadurch gekennzeichnet, daß die Stromführungen (6, 7) aus eng nebeneinander angeordneten Leitern ausgebildet sind, die auch gerade Strecken aufweisen.

4. Vierpol nach einem der Ansprüche 1 bis 3, dadurch gekennzeichnet, daß die Stromführungen (6, 7) auf Eisenkern ausgebildet sind.

5. Vierpol nach einem der Ansprüche 1 bis 4, dadurch gekennzeichnet, daß die Kapazität einen Kondensator (8) enthält, dessen ein Belag einem gemeinsamen Punkt (5) der Stromführungen (6, 7) und der andere Belag dem eingeschalteten Punkt zugeführt ist.

6. Vierpol nach einem der Ansprüche 1 bis 4, dadurch gekennzeichnet, daß zwischen dem induktiven Reihenglied und einerseits dem ersten Eingangspunkt (1) sowie andererseits dem ersten Ausgangspunkt (3) je ein, vorteilig gleiche Kapazitanz gekennzeichneter Kondensator (9, 10, 13, 14) vorhanden ist, wobei die Kondensatoren (9, 10, 13, 14) vorteilig gleiche Kapazitanz aufweisen.

7. Vierpol nach einem der Ansprüche 1 bis 6 dadurch gekennzeichnet, daß zwischen dem Filterglied (20) und einerseits dem ersten Eingangspunkt (1) sowie andererseits dem ersten Ausgangspunkt (3) je eine Wicklung (15, 16) vorhanden ist, deren Impedanzen vorteilig gleich sind.

8. Vierpol nach Anspruch 7, dadurch gekennzeichnet, daß die näher zum Filterglied (20) liegenden Punkte der Wicklungen (15, 16) miteinander verbunden sind.

9. Vierpol nach einem der Ansprüche 1 bis 6, dadurch gekennzeichnet, daß zwischen dem Filterglied (20) und einerseits dem ersten Eingangspunkt (1) sowie andererseits dem ersten Ausgangspunkt (3) je ein paralleles Glied vorhanden ist, das in paralleler Schaltung eine Wicklung (11, 12) und einen Kondensator (13, 14) enthält, wobei vorteilig die Kapazitanzen der Kondensatoren (13, 14) und die Impedanzen der Wicklungen (11, 12) gleich sind.

10. Vierpol nach einem der Ansprüche 7 bis 9, dadurch gekennzeichnet, daß die Wicklung (11, 12, 15, 16) mit Eisenkern versehen ist.

0073293

Fig.1

Fig.2

Fig.3

Fig.4

0073293

Fig.5

Fig.6

Fig.7

0073293

Fig. 8

Fig.9

Fig. 10

Fig.11

Fig.12

Fig.13

Fig.14

Fig.15

0073293

Fig.16